# EUROPEAN PATENT SPECIFICATION

(11) **EP 2 424 005 B1**
(45) Date of publication and mention of the grant of the patent: **08.10.2014**
(21) Application number: 11170491.2
(22) Date of filing: 20.06.2011
(51) Int. Cl.: H01M 2/20, H01M 6/50, H01M 10/02, H01M 10/42, H05K 1/18, H05K 3/34

(54) **Battery pack comprising a protection circuit module**
Batteriepack
Bloc-batteries

(30) Priority: 26.08.2010 US 377392 P; 14.03.2011 US 201113047592
(43) Date of publication of application: 29.02.2012
(73) Proprietor: Samsung SDI Co., Ltd., Yongin-si, Gyeonggi-do (KR)
(72) Inventor: Park, Sanghun, Gyeonggi-do (KR)
(74) Representative: Walaski, Jan Filip

(56) References cited:
- KR-A- 20070 075 945
- US-A1- 2010 178 549

## Description

The present invention relates to a battery pack. A battery pack includes a plurality of battery cells, also referred to herein as a multi-cell module, and a protection circuit module (PCM).

The unit cells making up the multi-cell module include rechargeable bare cells.

The PCM includes a field effect transistor (FET) as a switching element that blocks current, a resistor, capacitor, etc. The PCM controls charging/discharging operations of the unit cell, and prevents over-charge, over-discharge, over-current, etc.

The PCM is electrically connected to the unit cell by soldering.

However, in order to increase a coupling force between the PCM and the unit cell, an amount of solder used may increase. In this case, a height of a solder portion may increase. In addition, when the amount of solder used increases and the height of the solder portion is increased, a distance between the PCM and a case is reduced. Accordingly, a space for mounting other elements in the PCM is reduced, that is, distances between each of the elements become smaller, which may make the assembly process complicated.

US2010/178549 discloses a secondary battery having a connection arrangement for connecting battery cells to a protection circuit module.

Aspects of the present invention provide a battery pack having improved product reliability by reducing a height of a solder portion provided when a multi-cell module is connected to a protection circuit module (PCM) in series or parallel.

Aspects of the present invention also provide a battery pack having improved reliability in connecting a conductive lead to the PCM by increasing a contact area of the conductive lead of a connection circuit board and a solder portion when soldering the connection circuit board and the PCM.

According to the invention, there is provided a battery pack according to claim 1.

A battery pack may comprising one or more battery cells, a connecting circuit board connected to the one or more battery cells, the circuit board comprising one or more connectors for connecting the one or more battery cells to a protection circuit module PCM, the PCM having a through hole for receiving a corresponding one of the connectors, wherein each of the one or more connectors comprises a base portion and a receiving portion for holding solder, wherein the base portion is arranged to abut the PCM so as to seal one side of the through hole to prevent solder flowing through the through hole.

The receiving portion may comprise first and second protruding portions extending from the base portion and arranged to pass through the through hole in the PCM, the protruding portions being separated from one another by a gap and outside edges of the first and second protruding portions being rounded, wherein when the protruding portions are soldered to the PCM, the gap is arranged to receive solder.

The gap may have a substantially rectangular profile or may taper towards a bottom of the gap.

The battery pack may comprise further projections arranged between the first and second projections, such that the connector comprises three or more projections with gaps between them. The first and second projections may be joined at a top portion distal from the base portion such that the gap is enclosed by the projections. The gap may have a substantially circular or oval profile.

The PCM may comprise a substantially planar PCM circuit board and a bottom of the gap may be arranged to be in line with a top or a bottom surface of the PCM circuit board.

The battery pack may further comprise a protruding portion extending from the base portion and arranged to pass through the through hole in the PCM and a rounded cap at the top of the protruding portion, the cap having overhanging portions that define a gap between the overhanging portions and the base portion, wherein the gap comprises the receiving portion that is arranged to receive solder when the connector is soldered to the PCM.

The width of the rounded cap including the overhanging portions may not be greater than the width of the through hole.

The PCM may comprise a substantially planar PCM circuit board and a top of the base portion may be arranged to be in line with a top or a bottom surface of the PCM circuit board.

The ratio of the cross-sectional area of the gap to the cross-sectional area of the portion of the connector inserted into the through hole may be between 29% and 74%.

The PCM may comprise a substantially planar PCM circuit board and the connector may comprise a stepped portion arranged to be in contact with a first side of the PCM circuit board opposite the side at which the first and second projections protrude.

The connector may comprise an extension portion extending from the connecting circuit board and parallel to an insertion portion of the connector that is inserted into the through hole, the connector further comprising a bent portion between the extension portion and the insertion portion.

The PCM may include a substantially planar circuit board and a printed circuit pattern on the circuit board, wherein the printed circuit pattern is formed around the through hole and the connector is soldered to an upper portion of the printed circuit pattern.

The battery pack may comprise a plurality of battery cells, wherein each of the battery cells has a protective circuit element and first and second electrode tabs, the second electrode tab being connected to one end of the protective circuit element, the first electrode tab and a lead from the other end of the protective circuit element being connected to the connecting circuit board. As described above, in the connection circuit board of the present invention and the battery pack including the same, when a multi-cell module is connected to a printed circuit module in series or parallel, a height of a solder portion can be reduced.

In addition, in the connection circuit board of the present invention and the battery pack including the same, coupling reliability can be improved by increasing a contact area of a conductive lead and a solder portion of the connection circuit board.

Embodiments of the invention will now be described, by way of example, with reference to the accompanying drawings, in which:
FIG. 1 is a perspective view of a battery pack according to an embodiment of the present invention;
FIG. 2 is an enlarged perspective view of a portion A of FIG. 1;
FIG. 3 is a partially perspective view of a unit cell constituting the battery pack shown in FIG. 1;
FIG. 4 is a partially perspective view illustrating a connection relationship between the unit cell shown in FIG. 3 and a connection circuit board;
FIG. 5 is a perspective view illustrating a conductive lead and a via hole shown in

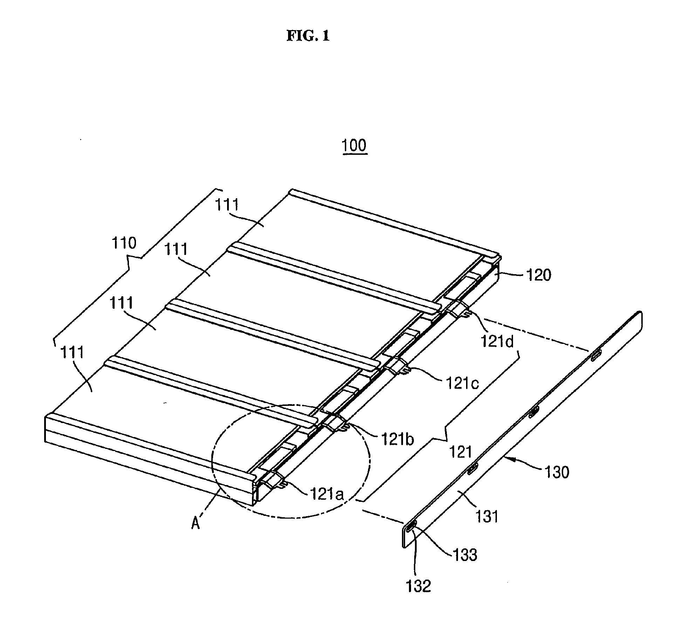

FIG. 1 separated from each other;

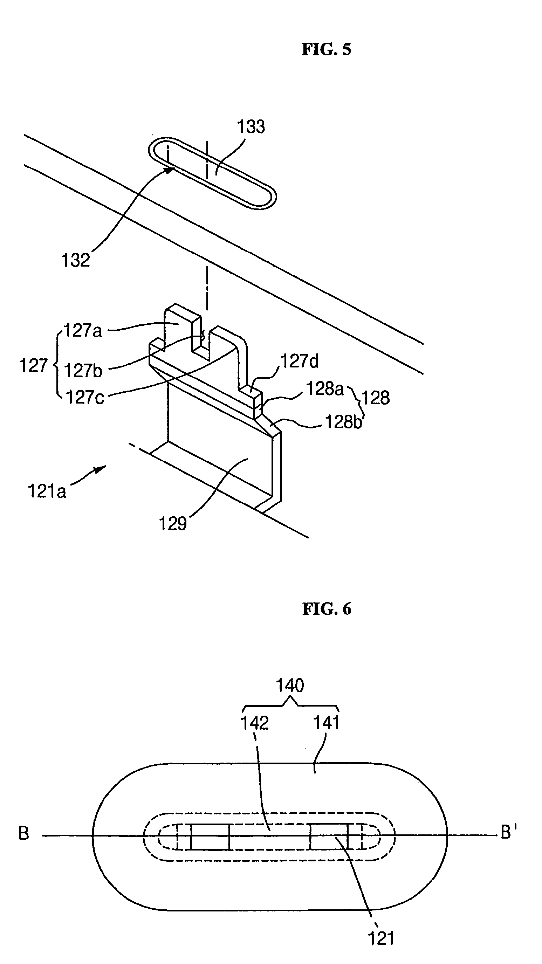

FIG. 6 is a front view of a soldering connection of FIG. 5;

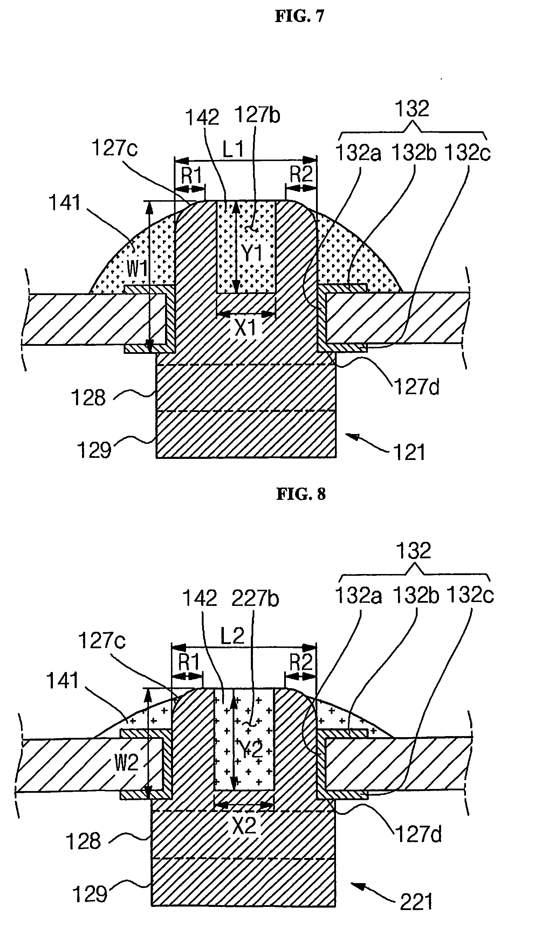

FIG. 7 is a vertical section view taken along the line B-B' of FIG. 6;
FIG. 8 is a vertical section view illustrating a portion of a battery pack according to another embodiment of the present invention;

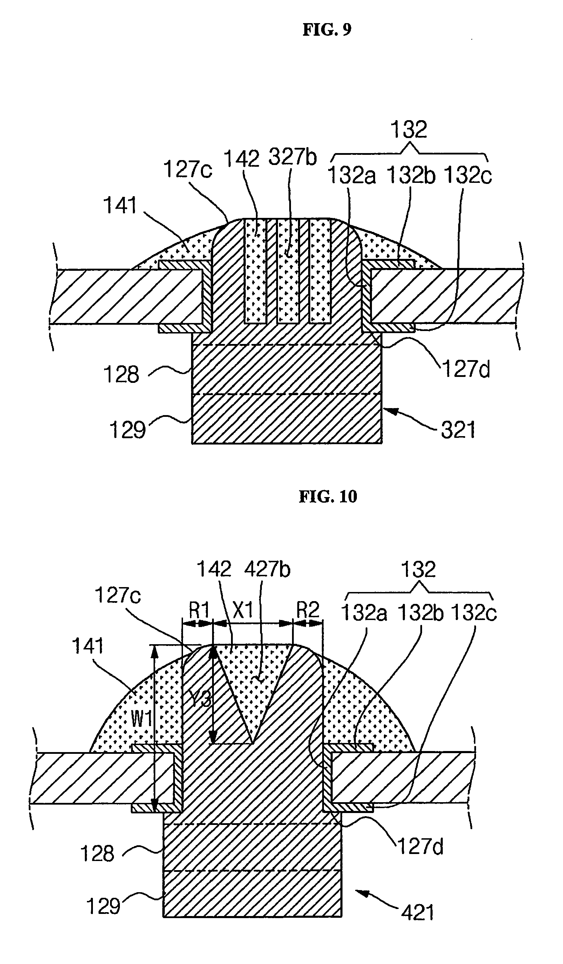

FIG. 9 is a vertical section view illustrating a portion of a battery pack according to still another embodiment of the present invention;
FIG. 10 is a vertical section view illustrating a portion of a battery pack according to still another embodiment of the present invention;

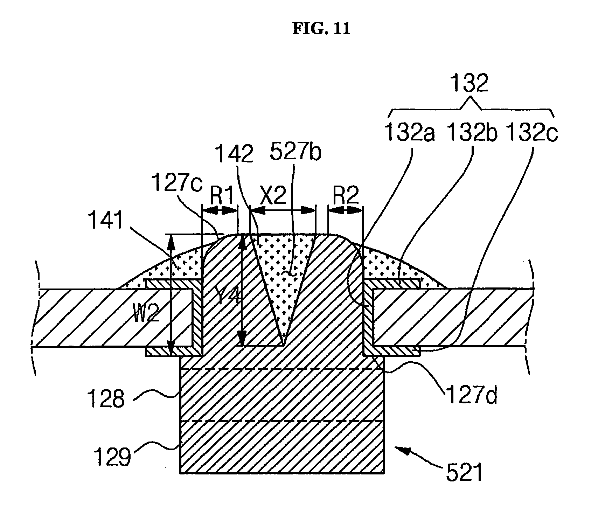

FIG. 11 is a vertical section view illustrating a portion of a battery pack according to still another embodiment of the present invention;

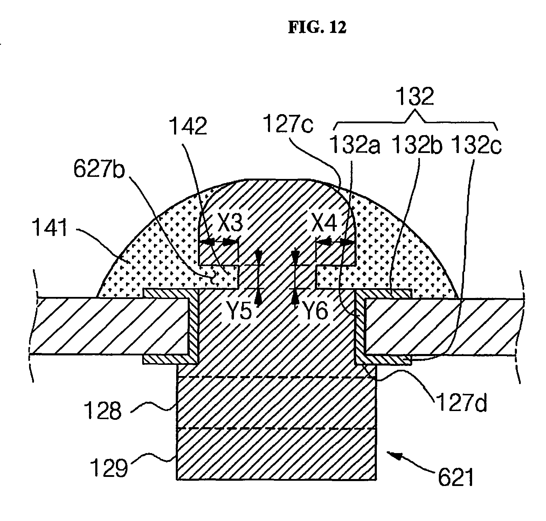

FIG. 12 is a vertical section view illustrating a portion of a battery pack according to still another embodiment of the present invention;

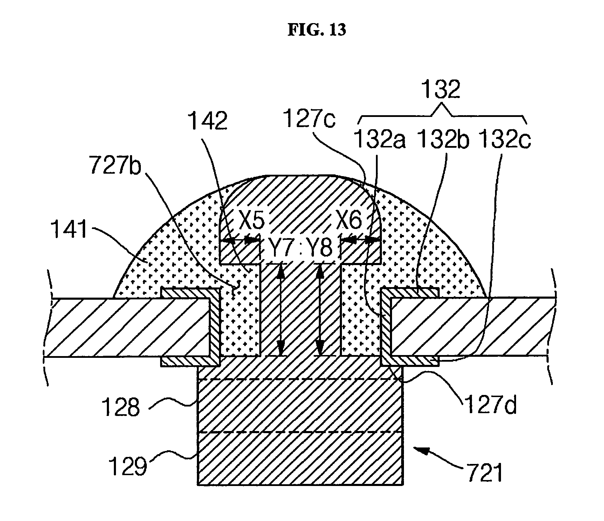

FIG. 13 is a vertical section view illustrating a portion of a battery pack according to still another embodiment of the present invention;

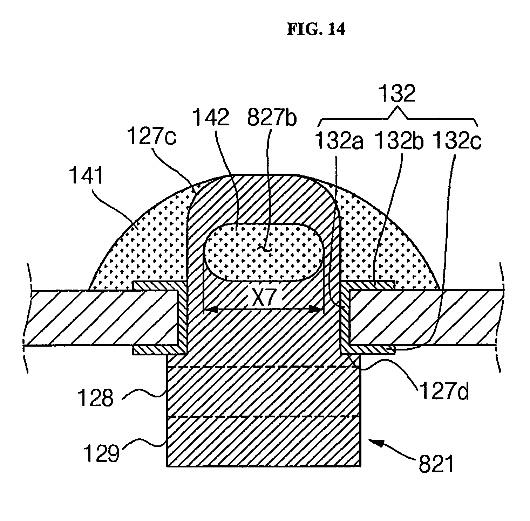

FIG. 14 is a vertical section view illustrating a portion of a battery pack according to still another embodiment of the present invention; and

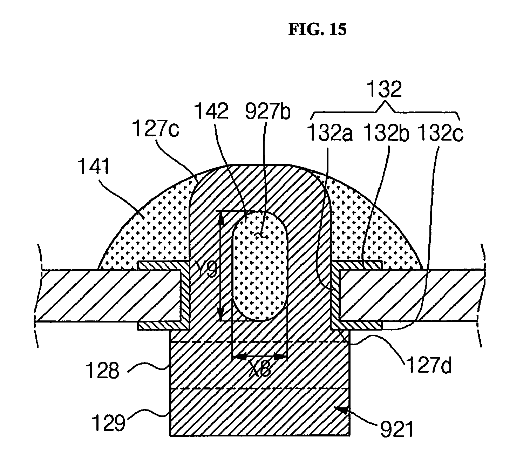

FIG. 15 is a vertical section view illustrating a portion of a battery pack according to still another embodiment of the present invention.

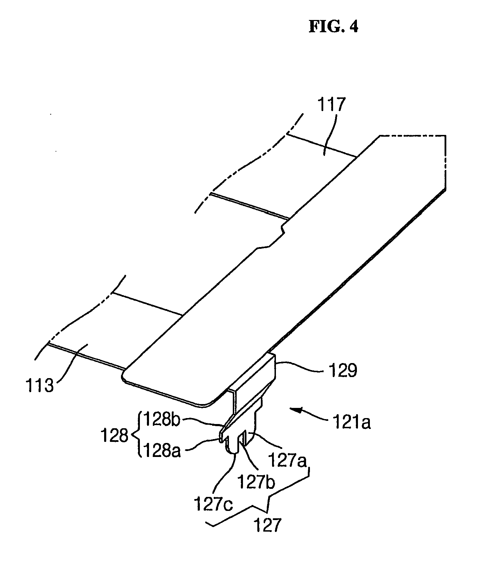

Referring to FIGS. 1 to 7, the battery pack 100 according to an embodiment of the present invention includes a multi-cell module 110, a connection circuit board 120, a protection circuit module (PCM) 130, and a solder portion 140.

The battery pack 100 has the multi-cell module 110 and the protection circuit module 130 electrically connected to each other. In the multi-cell module 110, a negative electrode tab or a positive electrode tab of each cell is connected to the connection circuit board 120. The connection circuit board 120 is electrically connected to the PCM 130 and is fixed by the solder portion 140.

The multi-cell module 110 includes a plurality of unit cells 111. The multi-cell module 110 is configured such that the unit cells 111 are connected in series or parallel to each other to provide a positive electrode and a negative electrode.

Each of the unit cells 111 includes a bare cell 112, a protective element 115, and a cover 119. The bare cell 112 includes an electrode assembly (not shown), a first electrode tab 113, and a second electrode tab 114.

The bare cell 112 accommodates the electrode assembly (not shown) and electrolyte. The bare cell 112 may be formed to have a shape that is the same as or similar to that of a general pouch-type battery, and a detailed description thereof will not be given.

The electrode assembly is configured by a negative electrode plate (not shown), a positive electrode plate (not shown), and a separator (not shown) sequentially stacked and wound.

The first electrode tab 113 and the second electrode tab 114 have different polarities from each other. That is to say, the first electrode tab 113 is electrically connected to the positive electrode plate of the electrode assembly, and the second electrode tab 114 is electrically connected to the negative electrode plate of the electrode assembly.

The protective element 115 includes a functional element 116, a first lead 116a, a second lead 116b, and a protective element lead tab 117.

The functional element 116 is, for example, a positive temperature coefficient (PTC) element. When the temperature of the unit cell 111 rises, internal resistance increases and blocks current.

The first lead 116a is electrically connected to the second electrode tab 114. The second lead 116b is electrically connected to the protective element lead tab 117.

The element lead tab 117 is plate-shaped and is made of the same material as that of the second electrode tab 114, or an electrically conductive material.

The cover 119 includes a cover body 119a and a cover fixing portion 119b.

In the cover 119, the protective element 115 is positioned at a sealing part 111a of the unit cell 111 and an upper portion of the unit cells 111 is subjected to a finishing process. The cover body 119a is rotated about a plane close to the sealing part 111a of the unit cell 111 and is coupled to the cover fixing portion 119b. Here, when the cover body 119a is coupled to the cover fixing portion 119b, the second electrode tab 114 connected to the first lead 116 of the protective element 115 is bent in a U-shape.

The cover body 119a is formed to accommodate the protective element 115 inside. In addition, the cover body 119a includes a first extraction hole 119c and a second extraction hole 119d formed at a location close to the sealing part 111a of the first extraction hole 119c, the first extraction hole 119c through which the first electrode tab 113 is drawn out, and the second extraction hole 119d through which the protective element lead tab 117 is drawn out. Hole 119e denotes a hole for welding the second electrode tab 114 and the first lead 116 to each other.

The cover fixing portion 119b is formed on upper portions of the unit cells 111. The cover body 119a and the cover fixing portion 119b are coupled to each other and the upper portions of the unit cells 111 are finished.

The connection circuit board 120 has a plurality of wire patterns (not shown) formed therein, and a conductive lead 121 drawn out outwardly. The conductive lead 121 may includes a multiple number of conductive leads 121a, 121b, 121c, and 121d according to the number of unit cells. Additionally, a general PCB may be used as the connection circuit board 120. Although not specifically shown, the connection circuit board 120 may include wire patterns (not shown) therein, like in a general flexible printed circuit board (FPCB).

The connection circuit board 120 is electrically connected to the first electrode tab 113 and the protective element lead tab 117 drawn out from the unit cell 111.

The conductive lead 121 is shaped of a plate made of a material having electrical conductivity, and includes an insertion portion 127, a bent portion 128b, and an extending portion 129. The conductive lead 121 is electrically connected to the PCM 130.

The insertion portion 127 includes a fixing portion 127a.

The fixing portion 127a comprises first and second projections having rounded outside edges 127c, the projections being separated from one another by a gap 127b, which acts as a receiving portion for the solder 140. The gap 127b may be rectangular, for example having a depth Y1 and width X1. The bottom of the gap 127b is in line with an upper surface of the PCB 130 when the insertion portion 127 has been inserted into a through hole in the PCB 130.

The gap 127b increases a contact area of the insertion portion 127 and the solder portion 140, thereby improving a coupling force therebetween.

The gap 127b may have the depth Y1 to have an increased strength. Here, a ratio of the cross-sectional area of the gap 127b to the cross-sectional area of the insertion portion 127 of the conductive lead 121 is in the range of 29 to 74%.

The area of the gap 127b is calculated based on its width X1 and depth Y1.

Assuming that the width X1 and depth Y1 of the gap 127b are 1 mm and 2.4 mm, respectively, the entire width L1 of the fixing portion 127a is 3 mm and an insertion height W1 is 2.75 mm, the area ratio may be calculated using the relationship (X1×Y1)/(L1×W1). In the illustrated embodiment, the area ratio is approximately 29%.

In addition, the rounded outside edges 127c, also referred to as a slanting portion, are formed by rounding both ends of the fixing portion 127a. The rounded surfaces of the slanting portion 127c may reduce a height of the solder portion 140 when the PCB 130 and the fixing portion 127a are coupled to each other.

Further, the insertion portion 127 has a stepped portion 127d so as to contact a bottom portion of the PCB 130. The stepped portion 127d is formed to have a width greater than the entire width of the insertion portion 127 at a location where it is formed to have a thickness equal to or greater than a thickness of the PCB 130 at both ends of the insertion portion 127.

The bent portion 128b is bent and extends from the stepped portion 127d via a straight portion 128a. The bending range is in a range of approximately 30 to 90 degrees from the direction in which the insertion portion 127 is inserted into the printed circuit module 130. Here, the bent portion 128b may vary so as to facilitate an assembling work of the battery pack.

In another embodiment, the portion 128a may also be bent in a similar way to the bent portion 128b.

The bent portion 128b is bent to prevent the solder portion 140 introduced from an upper portion of the PCB 130 from flowing downward.

The extending portion 129 is formed to be led to the bent portion 128b. When the insertion portion 127 is inserted into the PCM 130, the extending portion 129 facilitates an assembling work by upwardly or downwardly moving in view of the connection circuit board 120.

The PCM 130 includes an insulation board 131, a printed circuit pattern 132, and circuit elements (not shown). In addition, the PCM 130 may further include a connector (not shown).

The insulation board 131 has a via hole 133 passing through top and bottom surfaces thereof. The insulation board 131 is made of a resin-based material such as epoxy resin or bakelite. The insulation board 131 may include a plurality of compressed layers.

The via hole 133 is formed to have a tetragonal plane, preferably a rectangular plane having a width-to-depth ratio. The via hole 133 is a portion into which the insertion portion 127 is inserted. The via hole 133 is formed to pass through top and bottom surfaces of the insulation board 131. In the illustrated embodiment, the via hole 133 has its width that is longer than its depth.

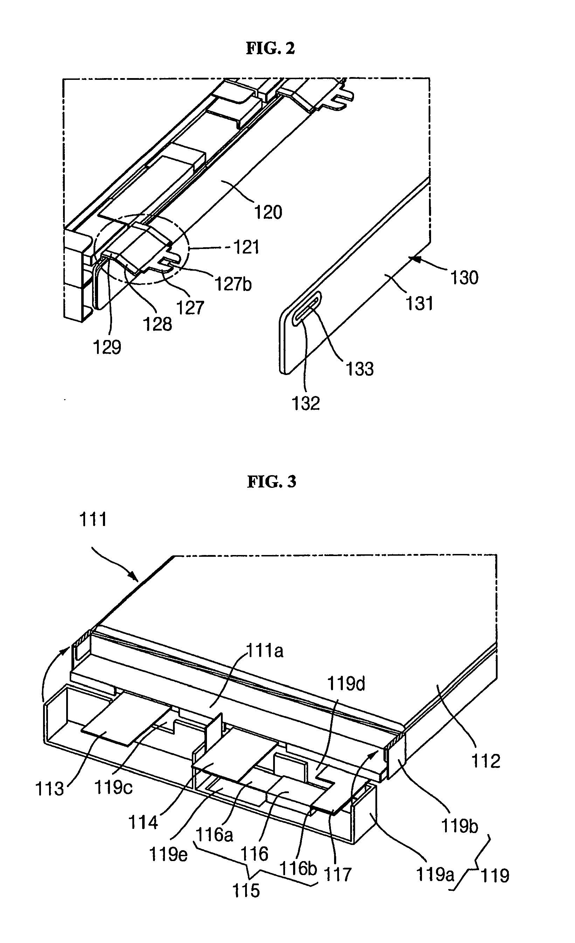

The printed circuit pattern 132 may be formed on a surface of the insulation board 131 by, for example, plating. The printed circuit pattern 132 may be formed to have various patterns according to the design of the PCM 130. In addition, the printed circuit pattern 132 may be formed on both of the top and bottom surfaces of the insulation board 131. The printed circuit pattern 132 may also be formed on an intermediate layer of the insulation board 131. FIG. 3 illustrates an example printed circuit pattern formed around the via hole 133.

The printed circuit pattern 132 includes an inner pattern 132a, an upper pattern 132b, and a lower pattern 132c.

The inner pattern 132a is formed on the internal surface of the via hole 133.

The upper pattern 132b is led to the inner pattern 132a and extends away from the inner pattern 132a on the top surface of the insulation board 131.

The lower pattern 132c is led to the inner pattern 132a and extends away from the inner pattern 132a on the bottom surface of the insulation board 131.

Since the inner pattern 132a, the upper pattern 132b, and the lower pattern 132c integrally cover the upper, middle and lower portions of the via hole 133, coupling forces between each of the inner pattern 132a, the upper pattern 132b and the lower pattern 132c, and the insulation board 131 are improved. Therefore, a coupling force between the solder portion 140 connected to the via hole patterns 132a and 132b and the PCM 130 is also improved.

The circuit elements (not shown) are placed on the insulation board 131 and are electrically connected to each other through the printed circuit pattern 132. The circuit elements measure voltages of the multi-cell module 110 and control charging/discharging of the multi-cell module 110 according to the charge/discharge state of the multi-cell 110. More specifically, the circuit elements include a charge field effect transistor (FET) (not shown), a discharge FET (not shown), a positive temperature coefficient (PTC) element (not shown), and a controller (not shown).

The connector (not shown) is placed on the top surface of the insulation board 131 and is electrically connected to the printed circuit pattern 132. In addition, the connector may be electrically connected to a battery connection terminal of a portable electronic device. In this case, the connector is exposed to the outside of a case (not shown) surrounding the multi-cell module 110 and the PCM 130.

Referring to FIG. 6, the solder portion 140 includes a first solder portion 141 and a second solder portion 142. The solder portion 140 is formed by soldering the PCM 130 and the insertion portion 127. The first solder portion 141 is formed outside the fixing portion 127a, and the second solder portion 142 is formed in the gap 127b. Here, the first solder portion 141 and the second solder portion 142 are integrally connected to increase a coupling force therebetween.

Since the first solder portion 141 and the second solder portion 142 are integrally formed, the solder portion 140 has an increased coupling force compared to a case where only the first solder portion 141 is provided. Therefore, an amount of solder introduced into the solder portion 140 may be reduced.

Next, a battery pack according to another embodiment of the present invention will be described.

FIG. 8 is a vertical section view illustrating a portion of a battery pack according to another embodiment of the present invention, corresponding to FIG. 7, in which a printed circuit module (PCM) and a conductive lead of a connection circuit board are connected to each other.

The battery pack according to the illustrated embodiment includes unit cells 111, a connection circuit board 120, a PCM 130 and a solder portion 140. In the illustrated embodiment, since the unit cells 111, the connection circuit board 120, the PCM 130 and the solder portion 140 are the same as above with reference to FIG. 7, functional elements that are the same as or similar to those shown in FIG. 7 are denoted by the same reference numerals, and detailed descriptions thereof will not be given.

In the conductive lead 221 according to the illustrated embodiment, a gap 227b has a constant width, and, a depth Y2 ranging from either end of the insertion portion 227 to a bottom portion of the PCM 130, as shown in FIG. 7. Here, the depth Y2 may be set such that the gap 227b may not extend beyond the bottom portion of the PCM 130. If the gap 227b extends beyond a lower extension line (not shown) of the PCM 130, the solder inserted into the gap 227b may flow out.

The gap 227b may be formed to have the maximum depth Y2 so as to increase coupling reliability of the first solder portion 141, the second solder portion 142 and the insertion portion 227 at the top portion of the PCM 130. Here, a ratio of the area of the gap 227b to the area of insertion portion 227 of the conductive lead 321 is in a range of 29 to 74%.

The area of the gap 227b is calculated based on the width X2 and depth Y2 of the internal space of the gap 227b. Assuming that the width X2 and depth Y2 of the gap 227b are 1.4 mm and 2.6 mm, respectively, the entire width L21 of the fixing portion 227a is 2 mm and an insertion height W1 is 2.45 mm, the area ratio may be calculated using the relationship (X2×Y2)/(L2×W2). In the illustrated embodiment, the area ratio is approximately 74%.

A battery pack according to still another embodiment of the present invention will now be described.

FIG. 9 is a vertical section view illustrating a portion of a battery pack according to still another embodiment of the present invention, in which a printed circuit module (PCM) 130 and a conductive lead 321 of a connection circuit board 120 are connected to each other.

The battery pack according to the illustrated embodiment includes unit cells 111, a connection circuit board 120, a PCM 130 and a solder portion 140.

In the conductive lead 321 according to the illustrated embodiment, a plurality of gaps 327b are provided. Accordingly, in the following description, the battery pack according to the illustrated embodiment will be described with regard to the gaps 327b of the connection circuit board 120. In FIG. 9, only the connection circuit board 120, the PCM 130 and the solder portion 140 are illustrated. Since the PCM 130 and the solder portion 140 are the same as above with reference to FIG. 1 to 7, functional elements that are the same as or similar to those shown in FIG. 1 to 7 are denoted by the same reference numerals, and detailed descriptions thereof will not be given.

In the conductive lead 321 according to the illustrated embodiment, the plurality of gaps 327b are provided to increase coupling reliability of the first solder portion 141, the second solder portion 142 and the insertion portion 127 at the top portion of the PCM 130. Here, a ratio of the area of the gap 327b to the area of insertion portion 127 of the conductive lead 321 is in a range of 29 to 74%.

A battery pack according to still another embodiment of the present invention will now be described.

FIG. 10 is a vertical section view illustrating a portion of a battery pack according to still another embodiment of the present invention, in which a printed circuit module (PCM) 130 and a conductive lead 421 of a connection circuit board 120 are connected to each other.

The battery pack according to the illustrated embodiment includes unit cells 111, a connection circuit board 120, a PCM 130 and a solder portion 140.

In the conductive lead 421 according to the illustrated embodiment, a gap 427b has a V-shape. Accordingly, in the following description, the battery pack according to the illustrated embodiment will be described with regard to the gap 427b of the connection circuit board 120. In FIG. 10, only the connection circuit board 120, the PCM 130 and the solder portion 140 are illustrated. In addition, functional elements that are the same as or similar to those shown in FIG. 1 to 7 are denoted by the same reference numerals, and detailed descriptions thereof will not be given.

The gap 427b is formed such that a width of its internal space gradually decreases toward the interior side of the conductive lead 421. The gap 427b is formed to range from the centre of its width to the top portion of the PCM 130 to be connected to the first solder portion 141, so that a contact area between the conductive lead 421 and the solder portion 140 may increase.

Therefore, in order to increase the reliability of coupling the connection circuit board 120 with the PCM 130, the gap 427b is formed to have the minimum depth Y3. Since the conductive lead 421 has the gap 427b having a reduced depth, the strength of the conductive lead 421 may be comparatively increased.

Here, a ratio of the area of the gap 427b to the area of an insertion portion 127 of the conductive lead 421 is in a range of 29 to 74%. Since the gap 427b having the minimum depth Y3 is the same as described above with reference to FIG. 5, functional elements that are the same as or similar to those of the previous embodiment are denoted by the same reference numerals, and detailed descriptions thereof will not be given. In the illustrated embodiment, the area ratio is approximately 29%.

A battery pack according to still another embodiment of the present invention will now be described.

FIG. 11 is a vertical section view illustrating a portion of a battery pack according to still another embodiment of the present invention, in which a printed circuit module (PCM) 130 and a conductive lead 521 of a connection circuit board 120 are connected to each other.

The battery pack according to the illustrated embodiment includes unit cells 111, a connection circuit board 120, a PCM 130 and a solder portion 140.

A depth of a gap 527b according to the illustrated embodiment may become maximized when the insertion portion 127 is inserted into a via hole 133. Here, the maximum depth Y4 corresponds to a depth ranging up to a bottom portion of the PCM 130, as shown in FIG. 11. If the gap 527b extends beyond a lower extension line (not shown) of the PCM 130, the solder inserted into the gap 527b may flow out.

The gap 527b is formed to range from the center of its width to the bottom portion of the PCM 130 to be connected to the first solder portion 141, so that a contact area between the conductive lead 521 and the solder portion 140 may become maximized.

Here, a ratio of the area of the gap 527b to the area of an insertion portion 127 of the conductive lead 521 is in a range of 29 to 74%. Since the gap 527b having the maximum depth Y4 is similar to that described above with reference to FIG. 10, functional elements that are the same as or similar to those of the previous embodiment are denoted by the same reference numerals, and detailed descriptions thereof will not be given. In the illustrated embodiment, the area ratio is approximately 29%. The area of the gap 527b is calculated based on the shape of the gap 527b, and a detailed explanation thereof will be omitted. In the illustrated embodiment, the area ratio may be approximately 74% or less.

A battery pack according to still another embodiment of the present invention will now be described.

FIG. 12 is a vertical section view illustrating a portion of a battery pack according to still another embodiment of the present invention, in which a printed circuit module (PCM) 130 and a conductive lead 621 of a connection circuit board 120 are connected to each other.

The battery pack according to the illustrated embodiment includes unit cells 111, a connection circuit board 120, a PCM 130 and a solder portion 140.

Referring to FIG. 12, the conductive lead 621 is distinguished from the conductive leads of the previous embodiments, in view of a configuration of a gap 627b. Accordingly, in the following description, the battery pack according to the illustrated embodiment will be described with regard to the gap 627b of the connection circuit board 120. In FIG. 12, only the connection circuit board 120, the PCM 130 and the solder portion 140 are illustrated. Functional elements that are the same as or similar to those shown in FIG. 1 to 7 are denoted by the same reference numerals, and detailed descriptions thereof will not be given.

The gap 627b may be formed at either side surface end of the fixing portion 127a. Here, one or more of the gap 627b may be formed in one direction or opposite directions of the fixing portion 127a. Therefore, the second solder portion 142 formed in the gap 627b is connected to a first solder portion 141 so as to increase a contact area between the second solder portion 142 and the fixing portion 127a. Since the conductive lead 621 has the gaps 627b having reduced widths X3 and X4 and depths Y5 and Y6, the strength of the conductive lead 621 may be comparatively increased.

Here, a ratio of the area of the gap 627b to the area of an insertion portion 127 of the conductive lead 621 is in a range of 29 to 74%.

The area of the gap 627b is obtained based on two widths X3 and X4 and depths Y5 and Y6 of the gap 627b. The sum of the two widths X3 and X4 of the gap 627b is smaller than the entire width of the insertion portion 127. For example, when the entire width of the insertion portion 127 is 4 mm, the sum of the two widths X3 and X4 of the gap 627b is 4 mm or less.

Alternatively, the two widths X3 and X4 of the gap 627b may be different from each other.

In the illustrated embodiment, the area ratio may be calculated using the relationship (Minimum area of gap)/(Maximum area of insertion portion). The area may be calculated based on the shape of the gap 627b, and a detailed explanation thereof will be omitted.

A battery pack according to still another embodiment of the present invention will now be described.

FIG. 13 is a vertical section view illustrating a portion of a battery pack according to still another embodiment of the present invention, in which a printed circuit module (PCM) 130 and a conductive lead 721 of a connection circuit board 120 are connected to each other.

The battery pack according to the illustrated embodiment includes unit cells 111, a connection circuit board 120, a PCM 130 and a solder portion 140.

Referring to FIG. 13, the conductive lead 721 is distinguished from the conductive leads of the previous embodiments, in view of a configuration of a gap 727b. That is to say, the gap 727b has widths X5 and X6, and depths Y7 and Y8, which area symmetrical to each other, but aspects of the invention are not limited to the illustrated embodiment in view of the length and number the gap 727b.

As shown in FIG. 13, the depths Y7 and Y8 of the gap 727b may not extend beyond the bottom portion of the PCM 130. If the gap 727b extends beyond a lower extension line (not shown) of the PCM 130, the solder inserted into the gap 727b may flow out.

Here, a ratio of the area of the gap 727b to the area of an insertion portion 127 of the conductive lead 721 is in a range of 29 to 74%.

The area of the gap 727b is obtained based on two widths X5 and X6 and depths Y7 and Y8 of the gap 727b. The sum of the two widths X5 and X6 of the gap 727b is smaller than the entire width of the insertion portion 127. For example, when the entire width of the insertion portion 127 is 4 mm, the sum of the two widths X5 and X6 of the gap 727b is 4 mm or less.

In the illustrated embodiment, the area ratio may be calculated using the relationship (Minimum area of gap)/(Maximum area of insertion portion). The area may be calculated based on the shape of the gap 727b, and a detailed explanation thereof will be omitted.

A battery pack according to still another embodiment of the present invention will now be described.

FIG. 14 is a vertical section view illustrating a portion of a battery pack according to still another embodiment of the present invention, in which a printed circuit module (PCM) 130 and a conductive lead 821 of a connection circuit board 120 are connected to each other.

The battery pack according to the illustrated embodiment includes unit cells 111, a connection circuit board 120, a PCM 130 and a solder portion 140.

Referring to FIG. 14, the conductive lead 821 is distinguished from the conductive leads of the previous embodiments, in view of a configuration of a gap 827b. Accordingly, in the following description, the battery pack according to the illustrated embodiment will be described with regard to the gap 827b of the connection circuit board 120. In FIG. 14, only the conductive lead 821, the PCM 130 and the solder portion 140 are illustrated. Functional elements that are the same as or similar to those shown in FIG. 1 to 7 are denoted by the same reference numerals, and detailed descriptions thereof will not be given.

In the illustrated embodiment, the gap 827b may be formed on a fixing portion 127a in the form of a through groove of a circular shape. The gap 827b may be formed in a circular or oval shape. The conductive lead 821 is formed to have the minimum area of the gap 821b. Since the conductive lead 821 occupies the minimum area of the gap 821 a, the strength of the conductive lead 821 may be comparatively increased.

Here, a ratio of the area of the gap 827b to the area of an insertion portion 127 of the conductive lead 821 is in a range of 29 to 74%.

With respect to the area of the internal space of the gap 827b, a width X7 of the gap 827b formed at either side surface end of the is smaller than the gap 827b is smaller than the entire width of the insertion portion 127.

In the illustrated embodiment, the area ratio may be calculated using the relationship (Minimum area of gap)/(Maximum area of insertion portion). The area may be calculated based on the shape of the gap 827b, and a detailed explanation thereof will be omitted. In the illustrated embodiment, the area ratio is approximately 29% or greater.

A battery pack according to still another embodiment of the present invention will now be described.

FIG. 15 is a vertical section view illustrating a portion of a battery pack according to still another embodiment of the present invention, in which a printed circuit module (PCM) 130 and a conductive lead 921 of a connection circuit board 120 are connected to each other.

The battery pack according to the illustrated embodiment includes unit cells 111, a connection circuit board 120, a PCM 130 and a solder portion 140.

Referring to FIG. 15, the conductive lead 921 is distinguished from the conductive leads of the previous embodiments, in view of a configuration of a gap 927b. Accordingly, in the following description, the battery pack according to the illustrated embodiment will be described with regard to the gap 927b of the connection circuit board 120. In FIG. 15, only the connection circuit board 120, the PCM 130 and the solder portion 140 are illustrated. Functional elements that are the same as or similar to those shown in FIG. 1 to 7 are denoted by the same reference numerals, and detailed descriptions thereof will not be given.

In modifications of the illustrated embodiment, the gap 927b may be formed on a fixing portion 127a so as to have various numbers and sizes. Here, the gap 927b is formed to have the maximum area. In addition, the gap 927b may be formed such that an outer circumferential surface of the gap 927b does not extend beyond a lower extension line (not shown) of the PCM 130. If the outer circumferential surface of the gap 927b extends beyond the lower extension line of the PCM 130, the solder inserted into the gap 727b may flow out.

Here, a ratio of the area of the gap 927b to the area of an insertion portion 127 of the conductive lead 921 is in a range of 29 to 74%.

With respect to the area of the internal space of the gap 927b, a width X8 of the gap 927b formed at either side surface end of the is smaller than the gap 927b is preferably smaller than the entire width of the insertion portion 127, and a depth Y9 of the gap 927b preferably smaller than a height of the fixing portion 127a.

In the illustrated embodiment, the area ratio may be calculated using the relationship (Minimum area of gap)/(Maximum area of insertion portion). The area may be calculated based on the shape of the gap 927b, and a detailed explanation thereof will be omitted. In the illustrated embodiment, the area ratio is approximately 74% or less.

Although the present invention has been described with reference to the preferred examples, the foregoing disclosure should be interpreted as illustrative only and it should be understood that various modifications and variations can be easily made by those skilled in the art without departing from the scope of the invention as defined in the appended claims.

## Claims

1. A battery pack comprising:
one or more unit cells (111);
a connecting circuit board (120) connected to the one or more unit cells (111), the circuit board (120) comprising one or more conductive leads (121) extending from the circuit board (120) for connecting the one or more unit cells (111) to a protection circuit module PCM (130), the PCM having a via hole (133) for receiving a corresponding one of the conductive leads (121);
wherein each of the one or more conductive leads (121) comprises a gap (127b, 227b, 327b, 427b, 527b, 627b, 727b, 827b, 927b) acting as a receiving portion for solder (140), wherein the conductive lead is arranged to pass through the via hole (133) in the PCM (130), and a stepped portion (127d) of the conductive lead is arranged to abut the PCM (130);
**characterized in that** the conductive lead is arranged to abut the PCM (130) to seal one side of the via hole to prevent solder (140) flowing through the via hole (133) when the conductive lead is soldered to the PCM.

2. The battery pack of claim 1, wherein the conductive leads further comprise first and second protruding portions (127a) extending from the stepped portion and arranged to pass through the via hole in the PCM (130), the protruding portions being separated from one another by the gap (127b, 227b, 327b, 427b, 527b, 827b, 927b) and outside edges (127c) of the first and second protruding portions being rounded, wherein when the protruding portions are soldered to the PCM, the gap is arranged to receive solder (142).

3. The battery pack of claim 2, wherein the gap (127b, 227b, 327b) has a substantially rectangular profile or wherein the gap (427b, 527b) tapers towards a bottom of the gap.

4. The battery pack of claim 2 or 3, comprising further protruding portions arranged between the first and second protruding portions, such that the conductive lead comprises three or more protruding portions with gaps (327b) between them.

5. The battery pack of claim 2, wherein the first and second protruding portions are joined at a top portion distal from the base portion such that the gap (827b, 927b) is enclosed by the protruding portions.

6. The battery pack of claim 5, wherein the gap has a substantially circular or oval profile.

7. The battery pack of any one of claims 2 to 6, wherein the PCM comprises a substantially planar PCM circuit board (131) and the stepped portion (127d) of the conductive lead is arranged to be in contact with a first side of the PCM circuit board opposite the side at which the first and second protruding portions protrude.

8. The battery pack of any one of the preceding claims, wherein the PCM comprises a substantially planar PCM circuit board (131) and a bottom of the gap (127b, 227b, 327b, 427b, 527b, 827b, 927b) is arranged to be in line with a top or a bottom surface of the PCM circuit board.

9. The battery pack of claim 2, further comprising:
a rounded cap at the top of the protruding portions, the cap having overhanging portions that define a gap (627b, 727b) between the overhanging portions and the stepped portion.

10. The battery pack of claim 9, wherein the width of the rounded cap including the overhanging portions is not greater than the width of the via hole.

11. The battery pack of claim 9 or 10, wherein the PCM comprises a substantially planar PCM circuit board (130) and a top of the base portion is arranged to be in line with a top or a bottom surface of the PCM circuit board.

12. The battery pack of any one of the preceding claims, wherein the ratio of the cross-sectional area of the gap to the cross-sectional area of the portion of the conductive lead inserted into the via hole is between 29% and 74%.

13. The battery pack of any one of the preceding claims, wherein the conductive lead comprises an extension portion (129) extending from the connecting circuit board (120) and parallel to an insertion portion (127a) of the conductive lead that is inserted into the via hole, the conductive lead further comprising a bent portion (128b) between the extension portion and the insertion portion.

14. The battery pack of any one of the preceding claims, wherein the PCM includes a substantially planar circuit board (131) and a printed circuit pattern (132) on the circuit board, wherein the printed circuit pattern is formed around the via hole (133) and the conductive lead is soldered to an upper portion of the printed circuit pattern.

15. The battery pack of any one of the preceding claims comprising a plurality of unit cells, wherein each of the unit cells has a protective circuit element (115) and first and second electrode tabs, the second electrode tab (114) being connected to one end of the protective circuit element, the first electrode tab (113) and a lead (117) from the other end of the protective circuit element being connected to the connecting circuit board (120).

## Patentansprüche

1. Batteriepack, umfassend:
- eine oder mehrere Einheitszellen (111);
- eine Anschlussleiterplatte (120), die an die eine oder die mehreren Einheitszellen (111) angeschlossen ist, wobei die Leiterplatte (120) eine oder mehrere leitfähige Zuleitungen (121) umfasst, die sich von der Leiterplatte (120) aus erstrecken, um die eine oder die mehreren Einheitszellen (111) an ein Schutzschaltungsmodul PCM (130) anzuschließen, wobei das PCM eine Bohrung (133) aufweist, um eine entsprechende der leitfähigen Zuleitungen (121) aufzunehmen;
wobei jede der einen oder der mehreren leitfähigen Zuleitungen (121) einen Zwischenraum (127b, 227b, 327b, 427b, 527b, 627b, 727b, 827b, 927b) umfasst, der als Empfangsabschnitt für Lötmetall (140) dient, wobei die leitfähige Zuleitung angeordnet ist, um durch die Bohrung (133) in das PCM (130) zu gehen, und ein Stufenabschnitt (127d) der leitfähigen Zuleitung angeordnet ist, um an dem PCM (130) anzuliegen;
**dadurch gekennzeichnet, dass** die leitfähige Zuleitung angeordnet ist, um an dem PCM (130) anzuliegen, um eine Seite der Bohrung abzudichten, um zu verhindern, dass Lötmetall (140) durch die Bohrung (133) fließt, wenn die leitfähige Zuleitung mit dem PCM verlötet wird.

2. Batteriepack nach Anspruch 1, wobei die leitfähigen Zuleitungen ferner erste und zweite vorstehende Abschnitte (127a) umfassen, die sich von dem Stufenabschnitt aus erstrecken und angeordnet sind, um durch die Bohrung in das PCM (130) zu gehen, wobei die vorstehenden Abschnitte durch den Zwischenraum (127b, 227b, 327b, 427b, 527b, 827b, 927b) voneinander getrennt sind, und die äußeren Kanten (127c) der ersten und zweiten vorstehenden Abschnitte abgerundet sind, wobei, wenn die vorstehenden Abschnitte mit dem PCM verlötet werden, der Zwischenraum angeordnet ist, um Lötmetall (142) aufzunehmen.

3. Batteriepack nach Anspruch 2, wobei der Zwischenraum (127b, 227b, 327b) ein im Wesentlichen rechteckiges Profil aufweist, oder wobei sich der Zwischenraum (427b, 527b) zum Boden des Zwischenraums hin verjüngt.

4. Batteriepack nach Anspruch 2 oder 3, ferner umfassend vorstehende Abschnitte, die zwischen den ersten und zweiten vorstehenden Abschnitte angeordnet sind, so dass die leitfähige Zuleitung drei oder mehrere vorstehende Abschnitte mit Zwischenräumen (327b) dazwischen umfasst.

5. Batteriepack nach Anspruch 2, wobei die ersten und zweiten vorstehenden Abschnitte an einem oberen Abschnitt, der zu dem Basisabschnitt distal ist, derart zusammengefügt werden, dass der Zwischenraum (827b, 927b) durch die vorstehenden Abschnitte eingeschlossen ist.

6. Batteriepack nach Anspruch 5, wobei der Zwischenraum ein im Wesentlichen kreisförmiges oder ovales Profil aufweist.

7. Batteriepack nach einem der Ansprüche 2 bis 6, wobei das PCM eine im Wesentlichen planare PCM-Leiterplatte (131) umfasst und der Stufenabschnitt (127d) der leitfähigen Zuleitung angeordnet ist, um in Kontakt mit einer ersten Seite der PCM-Leiterplatte gegenüber der Seite, auf der die ersten und zweiten vorstehenden Abschnitte vorstehen, in Kontakt zu stehen.

8. Batteriepack nach einem der vorhergehenden Ansprüche, wobei das PCM eine im Wesentlichen planare PCM-Leiterplatte (131) umfasst, und ein Boden des Zwischenraums (127b, 227b, 327b, 427b, 527b, 827b, 927b) angeordnet ist, um auf eine obere oder eine untere Oberfläche der PCM-Leiterplatte ausgerichtet zu sein.

9. Batteriepack nach Anspruch 2, ferner umfassend:
eine abgerundete Kappe an dem oberen Teil der vorstehenden Abschnitte, wobei die Kappe überhängende Abschnitte aufweist, die einen Zwischenraum (627b, 727b) zwischen den überhängenden Abschnitten und dem Stufenabschnitt definieren.

10. Batteriepack nach Anspruch 9, wobei die Breite der abgerundeten Kappe, welche die überhängenden Abschnitte umfasst, nicht größer als die Breite der Bohrung ist.

11. Batteriepack nach Anspruch 9 oder 10, wobei das PCM eine im Wesentlichen planare PCM-Leiterplatte (130) umfasst, und ein oberes Teil des Basisabschnitts angeordnet ist, um auf eine obere oder eine untere Oberfläche der PCM-Leiterplatte ausgerichtet zu sein.

12. Batteriepack nach einem der vorhergehenden Ansprüche, wobei das Verhältnis der Querschnittsfläche des Zwischenraums zur Querschnittsfläche des Abschnitts der leitfähigen Zuleitung, die in die Bohrung eingefügt ist, zwischen 29 % und 74 % liegt.

13. Batteriepack nach einem der vorhergehenden Ansprüche, wobei die leitfähige Zuleitung einen Verlängerungsabschnitt (129) umfasst, der sich von der Anschlussleiterplatte (120) aus und parallel zu einem Einfügungsabschnitt (127a) der leitfähigen Zuleitung, die in die Bohrung eingefügt wird, erstreckt, wobei die leitfähige Zuleitung ferner einen gebogenen Abschnitt (128b) zwischen dem Verlängerungsabschnitt und dem Einfügungsabschnitt umfasst.

14. Batteriepack nach einem der vorhergehenden Ansprüche, wobei das PCM eine im Wesentlichen planare Leiterplatte (131) und ein Leiterbahnenmuster (132) auf der Leiterplatte umfasst, wobei das Leiterbahnenmuster um die Bohrung (133) herum gebildet ist und die leitfähige Zuleitung an einem oberen Abschnitt des Leiterbahnenmusters angelötet ist.

15. Batteriepack nach einem der vorhergehenden Ansprüche, umfassend eine Vielzahl von Einheitszellen, wobei jede der Einheitszellen ein Schutzschaltungselement (115) und erste und zweite Elektrodenflachstecker aufweist, wobei der zweite Elektrodenflachstecker (114) an einem Ende des Schutzschaltungselements angeschlossen ist, wobei der erste Elektrodenflachstecker (113) und eine Zuleitung (117) vom anderen Ende des Schutzschaltungselements an die Anschlussleiterplatte (120) angeschlossen sind.

## Revendications

1. Bloc-piles comprenant :
une ou plusieurs cellule(s) unitaire(s) (111) ;
une carte de circuit imprimé de connexion (120) reliée à la ou aux plusieurs cellule(s) unitaire(s) (111), la carte de circuit imprimé (120) comprenant un ou plusieurs fil(s) conducteur(s) (121) s'étendant à partir de la carte de circuit imprimé (120) pour relier la ou les plusieurs cellule(s) unitaire(s) (111) à un module de circuit de protection PCM (130), le PCM ayant un trou d'interconnexion (133) destiné à recevoir un fil conducteur correspondant parmi les fils conducteurs (121) ;
dans lequel chacun du ou des plusieurs fils conducteurs (121) comprend un interstice (127b, 227b, 327b, 427b, 527b, 627B, 727b, 827b, 927b) agissant en tant que partie de réception pour soudure tendre (140), dans lequel le fil conducteur est agencé pour passer à travers le trou d'interconnexion (133) dans le PCM (130), et une partie étagée (127d) du fil conducteur est agencée de manière à venir en butée contre le PCM (130) ;
**caractérisé en ce que** le fil conducteur est agencé pour venir en butée contre le PCM (130) afin de sceller un côté du trou d'interconnexion pour empêcher la soudure tendre (140) de passer à travers le trou d'interconnexion (133) lorsque le fil conducteur est soudé au PCM.

2. Bloc-piles de la revendication 1, dans lequel les fils conducteurs comprennent en outre des première et deuxième parties en saillie (127a) s'étendant à partir de la partie étagée et agencées pour passer à travers le trou d'interconnexion dans le PCM (130), les parties en saillie étant séparées l'une de l'autre par l'interstice (127b, 227b, 327b, 427b, 527b, 827b, 927b) et les bords extérieurs (127c) des première et deuxième parties en saillie étant arrondis, dans lequel lorsque les parties en saillie sont soudées au PCM, l'interstice est agencé pour recevoir la soudure tendre (142).

3. Bloc-piles de la revendication 2, dans lequel l'interstice (127b, 227b, 327b) présente un profil substantiellement rectangulaire ou dans lequel l'interstice (427b, 527b) est fuselé vers le fond de l'interstice.

4. Bloc-piles de la revendication 2 ou 3, comprenant en outre des parties en saillie agencées entre les première et deuxième parties en saillie, de sorte que le fil conducteur comprenne trois parties en saillie ou plus avec des interstices (327b) entre elles.

5. Bloc-piles de la revendication 2, dans lequel les première et deuxième parties en saillie sont reliées au niveau d'une partie supérieure distale de la partie de base de sorte que l'interstice (827b, 927b) soit entouré par les parties en saillie.

6. Bloc-piles de la revendication 5, dans lequel l'interstice présente un profil substantiellement circulaire ou ovale.

7. Bloc-piles de l'une quelconque des revendications 2 à 6, dans lequel le PCM comprend une carte de circuit imprimé de PCM substantiellement plane (131) et la partie étagée (127d) du fil conducteur est agencée de manière à être en contact avec un premier côté de la carte de circuit imprimé de PCM opposé au côté au niveau duquel les première et deuxième parties en saillie font saillie.

8. Bloc-piles de l'une quelconque des revendications précédentes, dans lequel le PCM comprend une carte de circuit imprimé de PCM substantiellement plane (131) et un fond de l'interstice (127b, 227b, 327b, 427b, 527b, 827b, 927b) est agencé de manière à être aligné avec une surface supérieure ou inférieure de la carte de circuit imprimé de PCM.

9. Bloc-piles de la revendication 2, comprenant en outre :
un capot arrondi au sommet des parties en saillie, le capot ayant des parties en surplomb qui définissent un interstice (627b, 727b) entre les parties en surplomb et la partie étagée.

10. Bloc-piles de la revendication 9, dans lequel la largeur du capot arrondi comportant les parties en surplomb n'est pas supérieure à la largeur du trou d'interconnexion.

11. Bloc-piles de la revendication 9 ou 10, dans lequel le PCM comprend une carte de circuit imprimé de PCM substantiellement plane (130) et un sommet de la partie de base est agencé de manière à être aligné avec une surface supérieure ou inférieure de la carte de circuit imprimé de PCM.

12. Bloc-piles de l'une quelconque des revendications précédentes, dans lequel le rapport de l'aire de section transversale de l'interstice à l'aire de section transversale de la partie du fil conducteur inséré dans le trou d'interconnexion est compris entre 29% et 74%.

13. Bloc-piles de l'une quelconque des revendications précédentes, dans lequel le fil conducteur comprend une partie d'extension (129) s'étendant à partir de la carte de circuit imprimé de connexion (120) et parallèle à une partie d'insertion (127a) du fil conducteur qui est inséré dans le trou d'interconnexion, le fil conducteur comprenant en outre une partie courbée (128b) entre la partie d'extension et la partie d'insertion.

14. Bloc-piles de l'une quelconque des revendications précédentes, dans lequel le PCM comporte une carte de circuit imprimé substantiellement plane (131) et un tracé de circuit imprimé (132) sur la carte de circuit imprimé, dans lequel le tracé de circuit imprimé est formé autour du trou d'interconnexion (133) et le fil conducteur est soudé à une partie supérieure du tracé de circuit imprimé.

15. Bloc-piles de l'une quelconque des revendications précédentes, comprenant une pluralité de cellules unitaires, dans lequel chacune des cellules unitaires a un élément de circuit de protection (115) et des première et deuxième languettes d'électrode, la deuxième languette d'électrode (114) étant reliée à une extrémité de l'élément de circuit de protection, la première languette d'électrode (113) et un fil (117) provenant de l'autre extrémité de l'élément de circuit de protection étant reliés à la carte de circuit imprimé de connexion (120).
